# EUROPEAN PATENT APPLICATION

(11) **EP 3 640 981 A1**
(43) Date of publication of application: **22.04.2020**
(21) Application number: 19187503.8
(22) Date of filing: 22.07.2019
(51) Int. Cl.: H01L 23/60, H01L 27/02

(54) **INTEGRATED CIRCUIT WITH ELECTROSTATIC DISCHARGE PROTECTION**

(30) Priority: 16.10.2018 EP 18200811
(71) Applicant: IDT Inc., San Jose, CA 95138 (US)
(72) Inventor: TAVANO, Giuseppe, 80992 München (DE); LAUBE, Michael, 01109 Dresden (DE)
(74) Representative: Lippert Stachow Patentanwälte Rechtsanwälte Partnerschaft mbB

(57) **Abstract**

The invention relates to an integrated circuit (1) with electrostatic discharge protection (2), comprising:
at least one die (3) comprising at least two different blocks (4, 5), each block (4, 5) comprising an electrostatic discharge protection (2),
a package (6) for containing the at least one die (3), and
a thermal pad (7) for dissipating heat of the at least one die (3),
wherein the at least one die (3) comprises for each block (4, 5) at least one input pad (8) and a ground pad (9) and the package (6) comprises for each input pad (8) and ground pad (9) of the at least one die (3) corresponding package pins (10), so that each input pad (8) and ground pad (9) of the at least one die (3) is connected to a corresponding package pin (10),
which is characterized in that each ground pad (9) of the at least one die (3) is additionally connected to the thermal pad (7) .

## Description

The invention relates to an integrated circuit with electrostatic discharge protection.

An integrated circuit, also referred to as IC, chip or microchip, is an electronic component comprising a set of electronic circuits. The integrated circuit can refer to analog, digital or mixed signal processing. The integrated circuit comprises at least one die, e.g. made of a semiconductor like silicone, which is contained in a package to protect the die. The die comprises according to the present invention at least two different blocks for processing different input signals.

The integrated circuit, particularly each block of the die, comprises an electrostatic discharge (ESD) protection. Furthermore, the integrated circuit comprises a thermal pad for dissipating heat of the at least one die.

The at least one die of the integrated circuit usually comprises for each block at least one input pad and a ground pad. The package of the integrated circuit comprises for each input pad and ground pad of the at least one die corresponding package pins, so that each input pad and ground pad of the at least one die is connected to a corresponding package pin.

From the prior art it is known that the at least two different blocks of the at least one die share the same ground. However, due to the shared ground the noise generated by one block of the die can affect the functionality of the other block of the die because the noise could couple through the shared ground connection.

To decouple the different blocks of an integrated circuit it is known from the prior art to connect each block to a common bus, called ESD bus, via anti-parallel diodes. This guarantees that the ESD ring is closed and that the blocks are decoupled by two diodes in series, one diode for each connection of a block to the ESD bus. However, in the worst case the ESD path comprises three diodes which must be passed, thereby weakening the ESD protection. Furthermore, high frequency noise can still travel from one block to the other since the diodes act as capacitances.

It is therefore an object of the present invention to provide an integrated circuit with good electrostatic discharge protection comprising at least two decouple blocks.

The object is solved by an integrated circuit with electrostatic discharge protection, comprising:
at least one die comprising at least two different blocks, each block comprising an electrostatic discharge protection,
a package for containing the at least one die, and
a thermal pad for dissipating heat of the at least one die,
wherein the at least one die comprises for each block at least one input pad and a ground pad and the package comprises for each input pad and ground pad of the at least one die corresponding package pins, so that each input pad and ground pad of the at least one die is connected to a corresponding package pin,
which is characterized in that
each ground pad of the at least one die is additionally connected to the thermal pad.

Since the ground pad of each block of the at least one die is connected to the corresponding ground package pin and the thermal pad, there is a guaranteed electrostatic discharge path because the thermal pad provides a separate ground reference. Furthermore, the at least two blocks of the at least one die are decoupled to each other because they are only connected to each other via the thermal pad. This provides a good electrostatic discharge protection and decoupling between the different blocks of the at least one die. Preferably the thermal pad consists of or comprises a conductive material to provide the separate ground connection. In a preferred variant the thermal pad is electrically connected to a ground reference of the surroundings in a mounted condition.

The thermal pad is preferably at least partially contained in the package but has at least a thermal connection to the outside of the package respectively the integrated circuit to dissipate heat generated by the at least one die.

In a variant of the invention the electrostatic discharge protection of the block is a diode. Thus, each block comprises a diode as electrostatic discharge protection. The diode is arranged in parallel to the electronic circuit of the block to provide the electrostatic protection. For example, the cathode of the diode is connected to the input pad of the block and the anode is connected to the ground pad of the block.

According to a variant of the invention the at least one die comprises at least one sensitive circuit and at least one noisy circuit. The sensitive circuit corresponds to the first block of the at least one die and the noisy circuit corresponds to the second block of the at least one die. Since both blocks are decoupled via the thermal pad the noisy circuit does not negatively affect the sensitive circuit, although both circuits are located on the same die.

Particularly, the sensitive circuit is an analog circuit and/or the noisy circuit is an analog or digital circuit.

Pursuant to a variant of the invention the thermal pad is electrically isolated from the at least one die and thermally coupled to the at least one die. Preferably the thermal pad is electrically coupled to a ground reference of the surroundings in the mounted condition. Furthermore, the thermal pad is designed to dissipate the heat generated by the at least one die during operation to the surroundings of the integrated circuit during operation.

In a variant of the invention the input pads and/or ground pads of the at least one die are connected to the corresponding package pins by bond wires. According to a further variant of the invention the ground pads of the at least one die are connected to the thermal pad by bond wires. Using bond wires to connect the input pads and/or ground pads to the corresponding package pins respectively to the thermal pad is easy and cheap.

Pursuant to a particularly preferred variant of the invention the bond wires between the ground pads of the at least one die and the thermal pad each form an inductance. Thus, the ground pads of the at least of die are connected to the thermal pad via an inductance. Since the inductance is a high impedance at high frequency the at least two blocks are also decoupled for high-frequency noise originating from one block of the at least one die. Preferably, the inductance of the bond wires between the ground pads of the at least one die and the thermal pad is between 1 pH and 999 nH, preferably between 100 pH and 100 nH. Advantageously, the inductance of the bond wires is matched to the frequency of the expected noise.

In the following the invention will be further explained with respect to the embodiment shown in the figure. It shows:

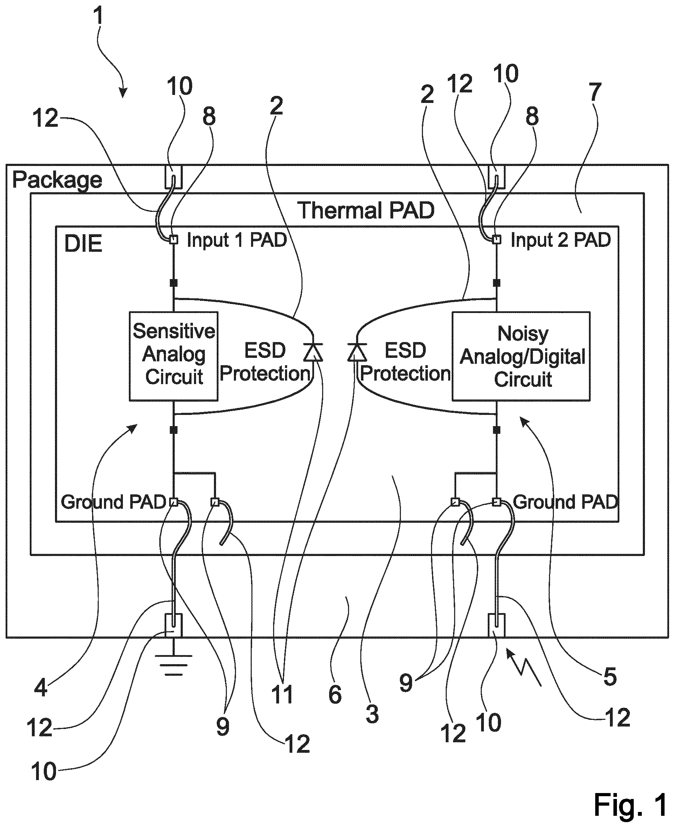

- Fig. 1: a schematic view of an embodiment of an integrated circuit according to the invention.

Fig. 1 shows a schematic view of an embodiment of an integrated circuit 1 with electrostatic discharge protection 2. The integrated circuit 1 comprises at least one die 3 with at least two different blocks 4, 5. Each of the blocks 4, 5 comprises a separate electrostatic discharge protection 2.

The integrated circuit 1 further comprises a package 6 for containing the at least one die 3 and a thermal pad 7 for dissipating heat of the at least one die 3.

The at least one die 3 comprises for each block 4, 5 at least one input pad 8 and a ground pad 9 and the package 6 comprises for each input pad 8 and ground pad 9 of the at least one die 3 corresponding package pins 10. Each input pad 8 and ground pad 9 of the at least one die 3 is connected to a corresponding package pin 10.

According to the invention each ground pad 9 of the at least one die 3 is additionally connected to the thermal pad 7.

According to the embodiment shown in Fig. 1 the electrostatic discharge protection 2 of each block 4, 5 is a diode 11. Particularly, the cathode of the diodes 11 are connected to the respective input pads 8 of the at least one die 3 and the anode of the diodes 11 are connected to the respective ground pads 9 of the at least one die 3.

The at least one die 3 of the integrated circuit 1 shown in Fig. 1 comprises two separate blocks 4, 5, namely a sensitive circuit 4 and a noisy circuit 5. The sensitive circuit 4 is analog circuit and the noisy circuit 5 is an analog or digital circuit.

The thermal pad 7 of the integrated circuit 1 is electrically isolated from the at least one die 3, except the connection between the ground pads 9 and the thermal pad 7, and thermally coupled to the at least one die 3.

The input pads 8 and ground pads 9 of the at least one die 3 are connected to the corresponding package pins 10 by bond wires 12. Furthermore, the ground pads 9 of the at least one die 3 are connected to the thermal pad 7 by bond wires 12.

Advantageously, the bond wires 12 between the ground pads 9 of the at least one die 3 and the thermal pad 7 each form an inductance. The inductance of the bond wires 12 between the ground pads 9 of the at least one die 3 and the thermal pad 7 is between 1 pH and 999 nH, preferably between 100 pH and 100 nH.

### List of reference numerals

- 1: integrated circuit
- 2: electronic discharge protection
- 3: die
- 4: block (sensitive circuit)
- 5: block (noisy circuit)
- 6: package
- 7: thermal pad
- 8: input pad
- 9: ground pad
- 10: package pin
- 11: diode
- 12: bond wire

## Claims

1. Integrated circuit (1) with electrostatic discharge protection (2), comprising:
at least one die (3) comprising at least two different blocks (4, 5), each block (4, 5) comprising an electrostatic discharge protection (2),
a package (6) for containing the at least one die (3), and
a thermal pad (7) for dissipating heat of the at least one die (3),
wherein the at least one die (3) comprises for each block (4, 5) at least one input pad (8) and a ground pad (9) and the package (6) comprises for each input pad (8) and ground pad (9) of the at least one die (3) corresponding package pins (10), so that each input pad (8) and ground pad (9) of the at least one die (3) is connected to a corresponding package pin (10),
**characterized in that**
each ground pad (9) of the at least one die (3) is additionally connected to the thermal pad (7).

2. Integrated circuit (1) according to claim 2,
wherein the electrostatic discharge protection (2) of the block is a diode (11).

3. Integrated circuit (1) according to claim 1 or claim 2,
wherein the at least one die (3) comprises at least one sensitive circuit (4) and at least one noisy circuit (5).

4. Integrated circuit (1) according to claim 3,
wherein the sensitive circuit (4) is an analog circuit and/or the noise circuit (5) is an analog circuit or a digital circuit.

5. Integrated circuit (1) according to any of claims 1 to 4,
wherein the thermal pad (7) is electrically isolated from the at least one die (3) and thermally coupled to the at least one die (3).

6. Integrated circuit (1) according to any of claims 1 to 5,
wherein the input pads (8) and/or ground pads (9) of the at least one die (3) are connected to the corresponding package pins (10) by bond wires (12).

7. Integrated circuit (1) according to any of claims 1 to 6,
wherein the ground pads (9) of the at least one die (3) are connected to the thermal pad (7) by bond wires (12).

8. Integrated circuit (1) according to claim 7,
wherein the bond wires (12) between the ground pads (9) of the at least one die (3) and the thermal pad (7) each form an inductance.

9. Integrated circuit (1) according to claim 8,
wherein the inductance of the bond wires (12) between the ground pads (9) of the at least one die (3) and the thermal pad (7) is between 1 pH and 999 nH, preferably between 100 pH and 100 nH.
